# EUROPEAN PATENT SPECIFICATION

(11) **EP 3 648 267 B1**
(45) Date of publication and mention of the grant of the patent: **11.05.2022**
(21) Application number: 18204066.7
(22) Date of filing: 02.11.2018
(51) Int. Cl.: H01S 5/50, G02B 6/255, G02B 6/35, H01S 5/10, G02F 1/025

(54) **OPTICAL AMPLIFIER**
OPTISCHER VERSTÄRKER
AMPLIFICATEUR OPTIQUE

(43) Date of publication of application: 06.05.2020
(73) Proprietor: Huawei Technologies Co., Ltd., Shenzhen, Guangdong 518129 (CN)
(72) Inventor: LEALMAN, Ian, 80992 Munich (DE)
(74) Representative: Gill Jennings & Every LLP

(56) References cited:
- EP-A1- 3 376 614
- US-A1- 2003 067 675
- US-A1- 2003 113 067
- US-A1- 2005 025 414
- US-A1- 2006 193 592
- US-A1- 2012 002 696
- US-A1- 2016 079 730

## Description

### BACKGROUND

This invention relates to optical amplifier devices, for example to improving the input power range of such devices.

High-performance and low-cost semiconductor optical amplifier (SOA) and variable optical attenuator (VOA) modules are used in applications such as large-capacity and high-speed optical access networks.

A conventional optical amplifier comprises a semiconductor block which has a front face or facet, a rear face or facet opposite to the front facet and an optical cavity formed therebetween. The cavity traditionally comprises an active layer interposed between layers of p- or n-type semiconductor material and defines a waveguide structure, which may be a ridge waveguide (RW) or a buried heterostructure (BH) waveguide. One or more coating layer(s), such as anti-reflection (AR) coatings, may be applied to the front and the rear facets.

The bias current supplied to the device can be controlled so that there is gain along the cavity by stimulation of the active region of the device, resulting in amplification.

Compact modules are needed that can operate over distances of 0 to 40km without forward error correction (FEC), or 80km with FEC. In the current generation of modules this is achieved by using separately packaged SOA and VOA components. However, the use of two chips and separate packages is both too large and too expensive for the planned next generation modules.

One approach is to replace the power detector in the receiver with an avalanche photodiode (APD). However, this approach can only cover a transmission distance of 30km without FEC (ER4 lite), which falls short of the 40km distance required in the ER4 standard.

It is desirable to produce an improved compact optical amplifier device that can operate over larger distance and over a wide range of input powers.

US 2003/0113067 A1 discloses a monolithically integrated smart optical add/drop multiplexer module on a multifunctional intelligent optical module platform.

### SUMMARY OF THE INVENTION

According to a first aspect there is provided an optical amplifier device as defined in claim 1. Preferred embodiments are defined in the dependent claims.

Varying the degree of optical coupling between the input port and the optical amplifier provides an effective way of varying the amplitude of the light that enters the optical amplifier to thereby alter the gain of the optical amplifier device. This approach results in a compact module that can operate over the desired distances of 0 to 40km without FEC or 80km with FEC by providing a monolithic SOA/VOA with a variable degree of coupling that can operate over a wider dynamic range of input powers.

Varying the degree of optical coupling between the two waveguides provides an effective way of altering the amplitude of the light that enters the optical amplifier to thereby alter the gain of the optical amplifier device.

One of the first and second waveguides may extend between the input port and a coupling region and the other of the first and second waveguides extends between the coupling region and the optical amplifier. This allows the amplitude of the light that enters the optical amplifier to be varied.

The optical path comprises a first waveguide, the first waveguide being moveable to alter the degree of optical coupling between it and the input port and thereby alter the degree of optical coupling between the input port and the optical amplifier. Moving one waveguide relative to the other waveguide provides an effective way of altering the degree of coupling and therefore the amplitude of the light that enters the optical amplifier to thereby alter the gain of the optical amplifier device.

At least part of the first waveguide may be in the form of a flexible beam that can be bent to alter the degree of optical coupling between it and the second waveguide. This design is easy to manufacture, as the waveguide can be undercut to form the beam.

In an exemplary embodiment, not falling under the scope of claim 1, the first waveguide may be moveable under electrostatic force and the optical amplifier device may comprise an electrostatic element for exerting an electrostatic force on the first waveguide. In the embodiment of the present invention, the first waveguide may be moveable under the action of heat and the optical amplifier device may comprise a heater for heating the first waveguide. These are effective ways of controlling the degree of coupling between the two waveguides.

The optical amplifier device may comprise a first power detector for detecting a power of a signal received at the input port. The optical amplifier device may comprise a second power detector for detecting a power of a signal subsequent to the said optical path. This allows the power of the signal at the input to the device and before the signal enters the SOA section to be measured.

The optical amplifier device may comprise a controller configured to control the coupling element to implement a degree of coupling in dependence on the power detected by the first and/or second power detectors. The degree of coupling can therefore be tuned to result in a desired input power to the SOA section.

The controller may be configured to limit the power of a signal input to the optical amplifier by controlling the coupling element. This allows the input power to the SOA to be kept within a desired range.

The optical amplifier and the optical coupling element are defined on a single substrate.

This allows for reductions in size and cost of the device.

### BRIEF DESCRIPTION OF THE FIGURES

The present invention will now be described by way of example with reference to the accompanying drawings.

In the drawings:
Figure 1 shows a side view of an example of a conventional semiconductor device.
Figures 2 shows a cross-section along A-A of Figure 1.
Figure 3 shows an embodiment according to the invention, with a first and a second waveguides with a gap between them, where one or other guide position can be adjusted.
Figure 4 shows another embodiment, not falling under the invention, with an undercut guide at the input to the device to
provide the VOA function by adjusting the coupling to the input fibre or coupling lenses to the chip.
Figure 5 shows a schematic of the embodiment of Figure 3 utilising power taps to monitor the power of the signal at input and output power detectors.
Figure 6 shows the results of initial calculations of attenuation vs vertical offset for a passive guide structure that could be integrated with an SOA.

### DETAILED DESCRIPTION OF THE INVENTION

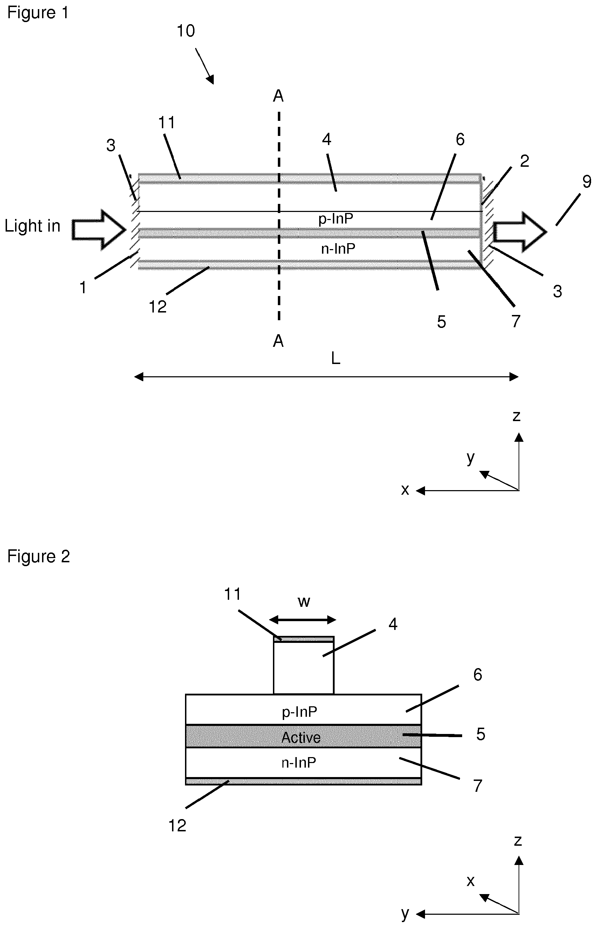

Figure 1 shows a side view of one example of a semiconductor optical amplifier 10. The device comprises a semiconductor block which has a front face or facet 1, a rear face or facet 2 opposite to the front face or facet and an optical cavity formed therebetween. The total length of the cavity is L. The cavity may be straight, as shown here, or the cavity may be inclined or at an angle relative to a direction perpendicular to the front facet.

It is preferable that the front and rear facets are aligned parallel to one another. The rear facet may be orthogonal to the length of the cavity. Preferably the front facet is orthogonal to the length of the cavity. An anti-reflection (AR) coating 3 can be applied to one or preferably both of the front and rear facets.

The cavity comprises an active layer 5 which may be interposed between layers of p-and n-type semiconductor material, shown at 6 and 7 respectively. The cavity may also comprise additional semiconductor outrigger layers beneath layers 5, 6 and 7. In this example, the semiconductor layers are made from InP. However, other semiconductor materials, such as GaAs, may be used. The material forming the cavity may be selectively doped in the region of the p- and n-type layers 6, 7. The optical cavity also comprises an etched waveguide layer 4, which provides lateral waveguiding.

The device has a common n electrode 12 on one side of the cavity, which may be adjacent to the floor of the cavity, and another electrode 11 on the opposite side of the cavity. The supply of a forward bias current to the electrodes of a section, such that the section acts as a gain section, causes light emission to be stimulated from that section of the cavity by applying a current across the electrodes. The supply of a reverse bias current to the electrodes, such that the cavity acts as an absorber section, causes light to be absorbed in that section of the cavity.

Light is emitted from the end of the waveguide at the rear face of the SOA device, shown at 9.

Figure 2 shows a vertical section along A-A of Figure 1. At each point along the length of the cavity, the waveguide layer 4 has a width w defined transverse to the length of the cavity. The width of the waveguide may be constant or it may vary along the length of the cavity. In the vertical section, the active layer 5, the confinement modification layer 8 and the semiconductor layers 6 and 7 all form part of the waveguide and guide the light in the vertical direction. The waveguide is thus formed by any layer or combination of layers that have a higher refractive index than the surrounding substrate and cladding layers, allowing the layer(s) to provide optical guiding.

The waveguide also has an optical confinement factor, Γ (Gamma). The optical confinement factor of a waveguide is defined as the proportion of the light in the guided mode which is contained within the active region or waveguide core. i.e. the section of the structure that generates the optical gain in the SOA device. The optical confinement factor of the waveguide may be constant or it may vary with position along the length of the cavity.

The waveguide may be a ridge waveguide. The ridge waveguide may be created by etching parallel trenches in the material either side of the waveguide layer 4 to create an isolated projecting strip, typically less than 5 µm wide and several hundred µm long. A material with a lower refractive index than the waveguide material can be deposited at the sides of the ridge to guide injected current into the ridge. Alternatively, the ridge may be surrounded by air on the three sides that are not in contact with the substrate beneath the waveguide. The ridge provides the lateral waveguiding, since the other layers in the structure above the active layer have a higher index than the air or passivation layers (typically silica or silicon nitride) in the etched channel regions.

Light may therefore enter the cavity at the front face 1 from an optical path and be amplified along the cavity before exiting the SOA device at the rear face 2, shown at 9.

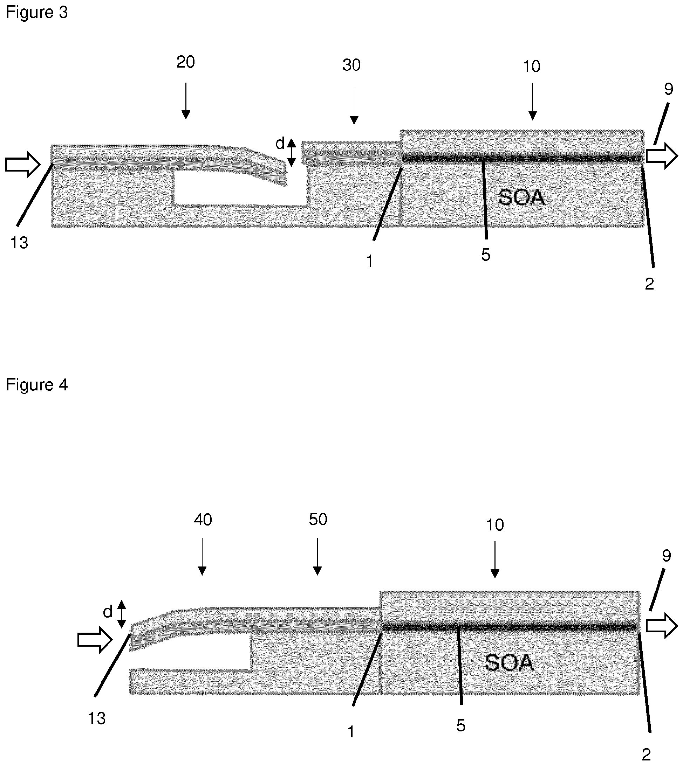

To control the input power of the light entering the SOA at the front face 1, the device according to the present invention monolithically integrates an SOA chip with a structure as described with reference to Figure 3 or Figure 4 which acts as a variable optical attenuator (VOA). The structure is formed from a passive optical coupling element which is variable to alter the degree of optical coupling between an input port of the device and the SOA to alter the power input and therefore the gain of the optical amplifier device.

Figure 3 shows a side view of a device where the optical path between the input to the device 13 and the SOA 10 comprises a moveable waveguide 20 and a stationary waveguide 30. The passive guides 20 and 30 are positioned adjacent to each other but have a gap between each other that interrupts the guiding of light along the device. The gap may be formed by etching away a portion of semiconductor material. In this example, waveguides 20 and 30 are ridge waveguides.

Waveguides 20, 30 may be designed to have very similar modal indices to the waveguide of the SOA 10, however the composition of them may be different. The waveguide 5 of the SOA may have either a bulk or MQW layer structure, while the passive waveguides 20, 30 may be a single layer of bulk quaternary semiconductor such as InGaAsP which will have a shorter bandgap wavelength than the SOA active to ensure it has low absorption over the operating wavelength range of the SOA. The guide layers of waveguides 20, 30 may also be thicker than the SOA active layer, since the passive guide layers of waveguides 20, 30 will have a lower refractive index than the SOA active region.

Electrodes are disposed on either side of the cavity via which a bias current can be supplied to the waveguide sections. There may be a common n-electrode disposed along the base of the cavity and separate p-electrodes disposed at the opposite side of the cavity for each of the sections 20, 30. Each of the waveguide sections 20, 30 may be independently biasable.

The moveable waveguide 20 is adjustable to alter the degree of optical coupling between it and the stationary waveguide 30 and thereby alter the degree of optical coupling between the input port 13 and the optical amplifier 10. As a result, the movable guide alters the amplitude of light at the input to the SOA section 10.

The moveable guide may be positioned adjacent to the input port 13, as in Figure 3, or alternatively adjacent to the SOA 10.

In the example of Figure 3, part of the moveable waveguide is in the form of a flexible beam that can be bent to alter the degree of optical coupling between the moveable waveguide and the stationary waveguide. The greater the displacement d of the beam towards the floor of the optical cavity, the greater the coupling loss. The minimum coupling loss occurs when the active layer of guide 20 is horizontally aligned with the active layer of guide 30 (when d=0).

The displacement of the moveable waveguide 20 is controlled thermally, by applying a voltage to the waveguide to adjust its electrostatic attraction. The device comprises a heater for heating the waveguide 20.

In other embodiments, not falling under the scope of the invention, the moveable waveguide is controlled electrostatically, the device comprises an electrostatic element for exerting an electrostatic force on the waveguide 20.

As the optical amplifier and the optical coupling element are monolithically integrated, they are defined on a single substrate, which reduces the size of the device.

Figure 4 shows another embodiment where the passive optical coupling element comprises an undercut guide 40 at the input to the SOA 10 adjacent to a stationary guide section 50 to provide the VOA function by adjusting the coupling to the input fibre or coupling lenses to the SOA. The undercut guide 40 can be controlled and displaced towards the floor of the cavity, as described above for moveable guide 20. Therefore the degree of optical coupling between the waveguides 40, 50 and the SOA 10 can be adjusted, thus controlling the amplitude of light at the input to the SOA.

The design of Figure 4 is easier to manufacture than the embodiment of Figure 3, as the undercut region is located at the end of the device, as opposed to the cantilever section being in the middle of the device.

In the case of minimum attenuation, the VOA losses should be of the order of 1dB, while in the maximum attenuation case, for a QSFP28 module targeting around 80km reach, the attenuation would be around 20dB or more.

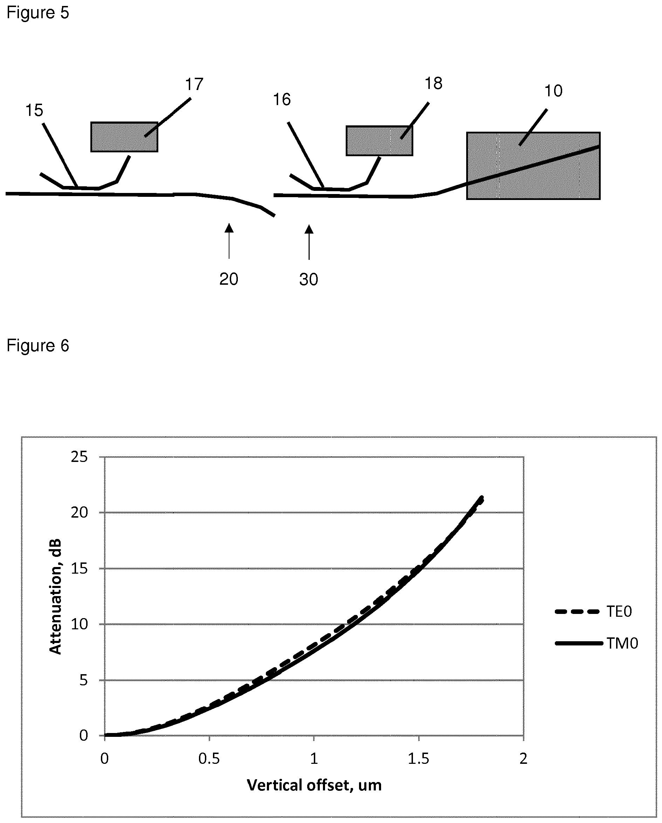

The device may also comprise an input power detector for detecting the power of the light signal received at the input port 13 and an output power detector for detecting the power of the signal at a position subsequent to the moveable waveguide. For example, the output power detector may detect the power of the signal before it enters the SOA 10. This may be achieved by using an input tap 15, and an output tap 16 at the end of the passive guide, as shown in Figure 5. The taps 15, 16 are designed to split off a small percentage of the light signal. The power of the respective signals can then be measured at these tap points by input and output power detectors, 17 and 18 respectively.

The device may comprise a controller configured to control the passive coupling element to implement a degree of coupling in dependence on the power detected by the input and/or output power detectors. The controller may be configured to limit the power of a signal input to the optical amplifier by controlling the coupling element.

The device may use power detectors with a lookup table to determine the safe working power range of the SOA and limit the power of the signal input to the optical amplifier accordingly.

In Figure 6, initial calculations have been performed for a passive guide structure that could be integrated with an SOA and the variation of attenuation with vertical offset is shown for the TE0 and TM0 modes. These calculations indicate that a vertical offset of just under 2µm is needed to provide around 20dB of variable attenuation.

This invention results in a compact module that can operate over the desired distances of 0 to 40km without FEC or 80km with FEC by providing a monolithic SOA/VOA that can operate over a wider dynamic range of input powers.

Although the examples above describe a device that has a ridge waveguide, the present invention can also be applied to devices having a buried heterostructure waveguide.

The waveguide of the SOA or the waveguide sections 20, 30 may be inclined relative to a direction perpendicular to the front face of the cavity such that the waveguide slopes upwards towards the rear face. The waveguide may be inclined relative to the cavity length by an angle of 5°, 10°, 15° or 20°.

This device could be integrated with other devices which benefit from variable amplification to allow for operation over a wider range of dynamic input powers. For example, the device could be integrated with an optical filter or demultiplexer followed by a power detector or array of power detectors.

## Claims

1. An optical amplifier device, the device comprising:
an input port (13) for receiving an optical signal;
an optical amplifier (10) for amplifying a signal input to the optical amplifier to form an amplified signal at an output of the optical amplifier device;
an optical path for conveying an optical signal from the input port to the optical amplifier, the optical path comprising an optical coupling element which is variable to alter the degree of optical coupling between the input port and the optical amplifier to thereby alter the gain of the optical amplifier device, wherein the optical amplifier and the optical coupling element are monolithically integrated and defined on a single substrate, and wherein the optical path comprises a first waveguide (20) and a second waveguide (30), the first waveguide being moveable relative to the second waveguide to alter the degree of optical coupling between the first waveguide and the second waveguide and thereby alter the degree of optical coupling between the input port and the optical amplifier, wherein the first waveguide is moveable under the action of heat and the optical amplifier device comprises a heater for heating the first waveguide.

2. An optical amplifier device as claimed in claim 1, wherein one of the first and second waveguides (20, 30) extends between the input port and a coupling region and the other of the first and second waveguides extends between the coupling region and the optical amplifier.

3. An optical amplifier device as claimed in any of the preceding claims, wherein at least part of the first waveguide (20) is in the form of a flexible beam that can be bent to alter the degree of optical coupling between it and the second waveguide.

4. An optical amplifier device as claimed in any of the preceding claims, wherein the first waveguide (20) is moveable under electrostatic force and the optical amplifier device comprises an electrostatic element for exerting an electrostatic force on the first waveguide.

5. An optical amplifier device as claimed in any preceding claim, comprising a first power detector (17) for detecting a power of a signal received at the input port.

6. An optical amplifier device as claimed in any preceding claim, comprising a second power detector (18) or detecting a power of a signal subsequent to the said optical path

7. An optical amplifier device as claimed in claim 5 or 6, comprising a controller configured to control the coupling element to implement a degree of coupling in dependence on the power detected by the first and/or second power detectors.

8. An optical amplifier device as claimed in claim 7, wherein the controller is configured to limit the power of a signal input to the optical amplifier by controlling the coupling element.

## Patentansprüche

1. Optische Verstärkervorrichtung, wobei die Vorrichtung Folgendes umfasst:
einen Eingabeanschluss (13) zum Empfangen eines optischen Signals;
einen optischen Verstärker (10) zum Verstärken eines Signals, das in den optischen Verstärker eingegeben wird, um ein verstärktes Signal an einer Ausgabe der optischen Verstärkervorrichtung auszubilden;
einen optischen Pfad zum Übermitteln eines optischen Signals von dem Eingabeanschluss zu dem optischen Verstärker, wobei der optische Pfad ein optisches Kopplungselement umfasst, das variabel ist, um den Grad der optischen Kopplung zwischen dem Eingabeanschluss und dem optischen Verstärker zu ändern, wobei dadurch die Zunahme der optischen Verstärkungsvorrichtung geändert wird, wobei der optische Verstärker und das optische Kopplungselement monolithisch integriert und auf einem einzelnen Substrat definiert sind, und wobei der optische Pfad einen ersten Wellenleiter (20) und einen zweiten Wellenleiter (30) umfasst, wobei der erste Wellenleiter relativ zu dem zweiten Wellenleiter bewegbar ist, um den Grad der optischen Kopplung zwischen dem ersten Wellenleiter und dem zweiten Wellenleiter zu ändern und wobei dadurch der Grad der optischen Kopplung zwischen dem Eingabeanschluss und dem optischen Verstärker geändert wird, wobei der erste Wellenleiter unter der Einwirkung von Hitze bewegbar ist die optische Verstärkervorrichtung einen Heizer zum Erhitzen des ersten Wellenleiters umfasst.

2. Optische Verstärkervorrichtung nach Anspruch 1, wobei sich der erste oder der zweite Wellenleiter (20, 30) zwischen dem Eingabeanschluss und einem Kopplungsbereich erstreckt und sich der andere des ersten oder des zweiten Wellenleiters zwischen dem Kopplungsbereich und dem optischen Verstärker erstreckt.

3. Optische Verstärkervorrichtung nach einem der vorhergehenden Ansprüche, wobei wenigstens ein Teil des ersten Wellenleiters (20) in der Form eines flexiblen Strahls vorliegt, der gebogen werden kann, um den Grad der optischen Kopplung zwischen ihm und dem zweiten Wellenleiter zu ändern.

4. Optische Verstärkervorrichtung nach einem der vorhergehenden Ansprüche, wobei der erste Wellenleiter (20) unter elektrostatischer Kraft bewegbar ist und die optische Verstärkervorrichtung ein elektrostatisches Element zum Ausüben einer elektrostatischen Kraft auf den ersten Wellenleiter umfasst.

5. Optische Verstärkervorrichtung nach einem der vorhergehenden Ansprüche, die einen ersten Leistungsdetektor (17) zum Erfassen einer Leistung eines Signals umfasst, das an dem Eingabeanschluss empfangen wird.

6. Optische Verstärkervorrichtung nach einem der vorhergehenden Ansprüche, die einen zweiten Leistungsdetektor (18) zum Erfassen einer Leistung eines Signals nachfolgend dem optischen Pfad umfasst.

7. Optische Verstärkervorrichtung nach Anspruch 5 oder 6, die eine Steuerung umfasst, die konfiguriert ist, um das Kopplungselement zu steuern, um einen Grad der Kopplung in Abhängigkeit von der Leistung zu implementieren, die durch den ersten und/oder den zweiten Leistungsdetektor erfasst wird.

8. Optische Verstärkervorrichtung nach Anspruch 7, wobei die Steuerung konfiguriert ist, um die Leistung eines Signals, das in den optischen Verstärker eingegebenen wird, durch Steuern des Kopplungselements zu begrenzen.

## Revendications

1. Dispositif amplificateur optique, le dispositif comprenant :
un port d'entrée (13) destiné à la réception d'un signal optique ;
un amplificateur optique (10) destiné à l'amplification d'une entrée de signal vers l'amplificateur optique afin de former un signal amplifié au niveau d'une sortie du dispositif amplificateur optique ;
un trajet optique destiné au transport d'un signal optique depuis le port d'entrée vers l'amplificateur optique, le trajet optique comprenant un élément de couplage optique qui est variable pour modifier le degré de couplage optique entre le port d'entrée et l'amplificateur optique afin de modifier ainsi le gain du dispositif amplificateur optique, l'amplificateur optique et l'élément de couplage optique étant intégrés de manière monolithique et définis sur un seul substrat, et le trajet optique comprenant un premier guide d'ondes (20) et un second guide d'ondes (30), le premier guide d'ondes étant mobile par rapport au second guide d'ondes pour modifier le degré de couplage optique entre le premier guide d'ondes et le second guide d'ondes et modifier ainsi le degré de couplage optique entre le port d'entrée et l'amplificateur optique, le premier guide d'ondes étant mobile sous l'action de la chaleur et le dispositif amplificateur optique comprenant un élément chauffant pour chauffer le premier guide d'ondes.

2. Dispositif amplificateur optique selon la revendication 1, l'un des premier et second guides d'ondes (20, 30) s'étendant entre le port d'entrée et une région de couplage et l'autre des premier et second guides d'ondes s'étendant entre la région de couplage et l'amplificateur optique.

3. Dispositif amplificateur optique selon l'une quelconque des revendications précédentes, au moins une partie du premier guide d'ondes (20) se présentant sous la forme d'un faisceau souple qui peut être courbé pour modifier le degré de couplage optique entre celui-ci et le second guide d'ondes.

4. Dispositif amplificateur optique selon l'une quelconque des revendications précédentes, le premier guide d'ondes (20) étant mobile sous une force électrostatique et le dispositif amplificateur optique comprenant un élément électrostatique pour exercer une force électrostatique sur le premier guide d'ondes.

5. Dispositif amplificateur optique selon l'une quelconque des revendications précédentes, comprenant un premier détecteur de puissance (17) pour détecter une puissance d'un signal reçu au niveau du port d'entrée.

6. Dispositif amplificateur optique selon l'une quelconque des revendications précédentes, comprenant un second détecteur de puissance (18) pour détecter une puissance d'un signal ultérieur audit trajet optique.

7. Dispositif amplificateur optique selon la revendication 5 ou 6, comprenant un dispositif de commande configuré pour commander l'élément de couplage afin de mettre en œuvre un degré de couplage en fonction de la puissance détectée par le premier et/ou le second détecteur de puissance.

8. Dispositif amplificateur optique selon la revendication 7, le dispositif de commande étant configuré pour limiter la puissance d'une entrée de signal vers l'amplificateur optique en commandant l'élément de couplage.
